# EUROPÄISCHE PATENTSCHRIFT

(11) **EP 0 456 887 B1**
(45) Veröffentlichungstag und Bekanntmachung des Hinweises auf die Patenterteilung: **27.09.1995**
(21) Anmeldenummer: 90122020.2
(22) Anmeldetag: 17.11.1990
(51) Int. Cl.: H05K 3/20

(54) **Elektrische Schaltungsanordnung**
Electrical circuit
Circuit électrique

(30) Priorität: 12.05.1990 DE 4015311
(43) Veröffentlichungstag der Anmeldung: 21.11.1991
(73) Patentinhaber: VDO Adolf Schindling AG, D-60487 Frankfurt (DE)
(72) Erfinder: Strobel, Henry, W-6231 Sulzbach/Ts. (DE); Wiese, Klaus, W-6231 Sulzbach/Ts. (DE)
(74) Vertreter: Klein, Thomas, Dipl.-Ing. (FH)

(56) Entgegenhaltungen:
- EP-A- 0 323 673
- US-A- 4 857 784
- Week 8114, Derwent Publications Ltd., London, GB; AN 81-24646D & JP-A56010795
- PATENT ABSTRACTS OF JAPAN, Bd. 13, Nr. 259 (E-773)15. Juni 1989;& JP-A-1054799
- PATENT ABSTRACTS OF JAPAN, Bd. 7, Nr. 230 (M-249)12. Oktober 1983;& JP-A-58122175

## Beschreibung

Die Erfindung betrifft eine elektrische Schaltungsanordnung, insbesondere zur Verwendung im Bereich des Antriebsstrangs eines Kraftfahrzeugs und einen Antriebsstrang eines Kraftfahrzeugs.

Es ist bekannt, elektrische Schaltungsanordnungen in der Weise aufzubauen, daß auf einem Trägerelement, beispielsweise aus Pertinax oder glasfaserverstärktem Epoxidharz, Leiterbahnen aus Kupfer mit Hilfe einer Additiv- oder Subtraktivtechnik aufgebracht werden.

Des weiteren ist eine elektrische Schaltungsanordnung mit einer Leiterbahnanordnung, wobei die Leiterbahnanordnung als Blechformteil ausgebildet ist, und die Anschlüsse des elektrischen Bauelemente mit dem Blechformteil verbunden sind aus dem Dokument "Patent Abstracts of Japan", vol. 13, no. 259 (E-773), 15. Juni 1989 & JP-A-10 54 799 (Matsushia Electric Works), 2. März 1989 bekannt.

Derartig aufgebaute Schaltungsanordnungen können aber nur bis zu einer maximalen Temperatur von ca. 125 °C eingesetzt werden. Während bei höheren Temperaturen die meisten elektrischen Bauelemente, insbesondere passive Bauelemente, ihre Funktion noch zufriedenstellend erfüllen können, besteht die Gefahr, daß der mechanische Aufbau der Schaltungsanordnung Schaden nimmt, worunter auch die elektrischen Verbindungen leiden.

Insbesondere auf dem Gebiet der Kfz-Sensorik, beispielsweise an Motor oder Getriebe werden Schaltungsanordnungen benötigt, die nicht nur höheren Temperaturen standhalten, sondern auch bei hohen Temperaturen uneingeschränkt funktionstüchtig sind.

Es ist daher die Aufgabe der vorliegenden Erfindung, eine Schaltungsanordnung anzugeben, die auch bei höheren Temperaturen eingesetzt werden kann.

Diese Aufgabe wird durch eine elektrische Schaltungsanordnung mit einem aus einem temperaturbeständigen Kunststoff hergestellten Trägerelement, einer damit verbundenen Leiterbahnanordnung und elektrischen Bauelementen gelöst, wobei die Leiterbahnanordnung als Blechformteil ausgebildet ist und die Anschlüsse der elektrischen Bauelemente mit dem Blechformteil verschweißt sind.

Diese elektrische Schaltungsanordnung kann aufgrund der höheren Temperaturbeständigkeit ihrer Einzelteile und der hohen Temperaturbeständigkeit der angewandten Verbindungstechnik zwischen den Einzelteilen in hohen Temperaturbereichen eingesetzt werden. Das Trägerelement aus einem temperaturbeständigen Kunststoff kann beispielsweise aus insbesondere glasfaserverstärktem Polyamid oder Polyesterimid bestehen und kann als Spritzgußteil hergestellt sein. Ein derartiges Trägerelement ist auch in Temperaturbereichen, die oberhalb von 125 °C liegen noch einsatzfähig. Auch das die Leiterbahnanordnung bildende Blechformteil ist ebenfalls hitzeresistent und in hohen Temperaturbereichen voll funktionsfähig. Das gleiche gilt für die elektrischen Bauelemente. Die Schweißverbindungen zwischen Bauelementen und Blechformteil halten ebenfalls höheren Temperaturen stand.

Es hat sich als günstig erwiesen, daß das Blechformteil als Blechstanz- und/oder Blechstanzbiegeteil ausgebildet ist. Das Herstellungsverfahren des Stanzens und des sich daran anschließenden Biegens der gestanzten Blechformteile ist kostengünstig und technisch präzise durchzuführen. Des weiteren bietet dieses Herstellungsverfahren eine große Variabilität und eine große Anpassungsfähigkeit bei der Herstellung verschiedenster Leiterbahnanordnungen.

Es hat sich bewährt, daß das Blechformteil wenigstens teilweise flächig auf dem Trägerelement aufliegt. Durch diese flächige Auflage des Blechformteils auf dem Trägerelement ist die Schaltungsanordnung gegen Schwingungen, die insbesondere im Bereich der Kfz-Sensorik besonderer Beachtung bedürfen, unempfindlich.

Von besonderem Vorteil ist es, daß das Trägerelement Vorsprünge aufweist, die durch Öffnungen im Blechformteil greifen und mit dem Blechformteil heißverstemmt sind. Bei der Herstellung des Trägerelements im Spritzgußverfahren werden die Vorsprünge auf dem Trägerelement im gleichen Arbeitsgang mit angeformt. Die zu diesen Vorsprüngen korrespondierenden Öffnungen in dem Blechformteil werden im Rahmen des Stanzvorgangs in das Blechformteil gestanzt, so daß auch für die Herstellung der Öffnungen kein zusätzlicher Arbeitsaufwand erforderlich ist. Durch den durch die Heißverstemmung hervorgerufenen Formschluß zwischen Trägerelement und Blechformteil ist eine zuverlässige Verbindung zwischen Trägerelement und Blechformteil sichergestellt.

In einer alternativen Ausführungsform hat es sich bewährt, daß das Blechformteil eingespritzt wird. Dabei wird das Blechformteil in ein Spritzgußwerkzeug gelegt und danach teilweise mit Kunststoffmaterial umgeben. Diese Technik ist vor allem dann angebracht, wenn beispielsweise die Breite der Leiterbahnen gering ist und gestanzte Öffnungen aus Stabilitätsgründen nicht ratsam sind.

Bewährt hat es sich weiterhin, daß die Anschlüsse der elektrischen Bauelemente mit dem Blechformteil laserverschweißt sind. Diese Verbindungstechnik hat den Vorteil, daß eine hohe Festigkeit bei hohen Temperaturen ohne Flußmittel erzielt wird. Die Bauelemente werden mit dem Blechformteil punktverschweißt, ohne daß dabei eine aufwendige und umständlich zu platzierende Schweißelektrode verwendet werden müßte.

Von besonderem Nutzen ist es, wenn ein Bauelement als Sensor ausgebildet ist. Dadurch kann die erfindungsgemäße Schaltungsanordnung in Bereichen eingesetzt werden, in denen variable Meßgrößen bei hohen Temperaturen erfaßt werden müssen.

Von Vorteil ist es dabei, wenn der Sensor als Bewegungssensor ausgebildet ist. Aufgrund dieser Ausbildung der erfindungsgemäßen Schaltungsanordnung wird es möglich, daß sich ändernde Bewegungsabläufe von technischen Bauteilen erfaßt werden können, die im Betrieb hohe Temperaturen annehmen.

Es hat sich dabei bewährt, daß mindestens einer der elektrischen Bauelemente als Hall-Sensor ausgebildet ist. Insbesondere in der Kraftfahrzeugsensorik, wo die bewegten Teile in der Regel aus Metall gebildet sind, lassen sich Bewegungen einfach und berührungsfrei erfassen.

Es ist von großem Vorteil, den Arbeitsstrang eines Kraftfahrzeuges mit einem Sensor auszustatten, der in einer erfindungsgemaßen Schaltungsanordnung angeordnet ist und ein der Drehzahl eines Teiles des Antriebsstrangs entsprechendes Signal erzeugt, wobei die Schaltungsanordnung in einem Bereich hoher Temperatur angeordnet ist. Dadurch kann die erfindungsgemäße Schaltungsanordnung zur Messung der Drehzahl eines Teiles des Arbeitsstranges ohne Rücksicht auf die am Meßpunkt jeweils herrschenden Temperaturverhältnisse eingesetzt werden. Somit ist eine bessere Überwachung der Änderungen der Drehzahl eines Teils des Arbeitsstranges möglich und zwar an der Stelle, an der durch extreme Temperaturen Messungen bislang nicht möglich waren. Durch den temperaturresistenten Aufbau der erfindungsgemäßen elektrischen Schaltungsanordnung ist eine Störanfälligkeit nicht zu befürchten.

Es hat sich dabei besonders bewährt, daß die Schaltungsanordnung in einem Motor angeordnet ist. Durch die direkte Anordnung der erfindungsgemäßen Schaltungsanordnung am Motor können dort direkt Messungen der Drehzahl durchgeführt werden. Dadurch werden durch lange Übertragungswege bedingte Meßfehler vermieden. Die Qualität der Meßwerte wird dadurch erheblich gesteigert.

Dies gilt insbesondere dann, wenn der Motor ein Verbrennungsmotor ist. An einem Verbrennungsmotor herrschen besonders extreme Temperaturbedingungen. Die Durchführung von Drehzahlmessungen an einem Verbrennungsmotor wird durch den Einsatz der erfindungsgemäßen Schaltungsanordnung besonders begünstigt.

Es hat sich außerdem bewährt, daß die Schaltungsanordnung in einem Getriebe angeordnet ist. Dabei hat sich neben der Temperaturbeständigkeit der erfindungsgemäßen Schaltungsanordnung auch deren Unempfindlichkeit gegenüber Schwingungen aufgrund der flächigen Auflage der Leiteranordnung auf dem Trägerelement bewährt.

Es hat sich gezeigt, daß die Temperatur am Arbeitsstrang größer als 125 °C sein kann. Selbst bei diesen hohen Temperaturen arbeitet die erfindungsgemäße Schaltungsanordnung ohne Störung und erzeugt der Drehzahl des Motors eines Kraftfahrzeuges entsprechende Signale.

Die Erfindung wird im folgenden anhand eines bevorzugten Ausführungsbeispiels in Verbindung mit der Zeichnung beschrieben. Darin zeigen:
- Fig. 1: ein Ausführungsbeispiel eines erfindungsgemäßen Blechformteils (in Draufsicht) und
- Fig. 2: eine Darstellung einer fertigen elektrischen Schaltungsanordnung.

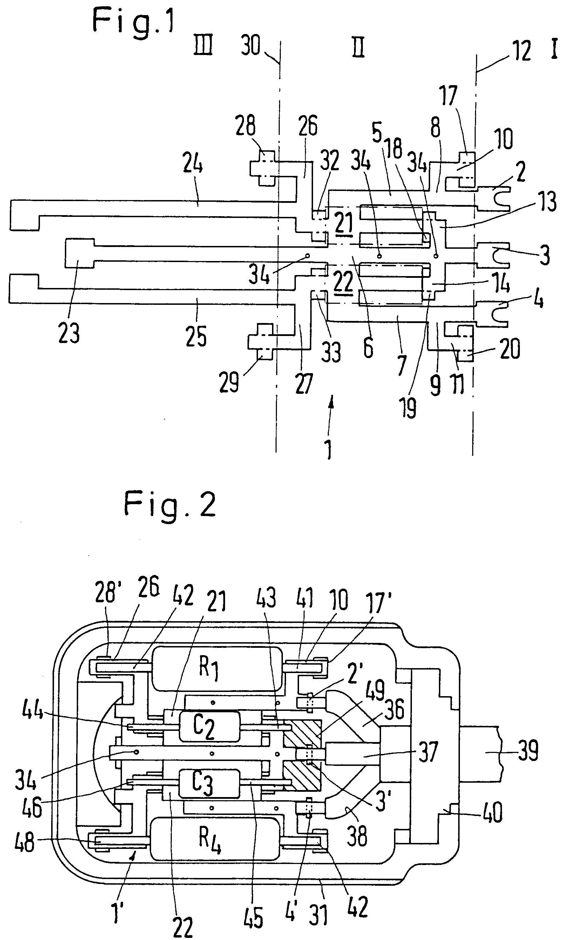

Das Blechformteil 1 ist ein Blechstanzbiegeteil und weist drei Anschlüsse 2, 3, 4 auf, die mit Stegen 5, 6, 7 verbunden sind. Von den Stegen 5, 7 Zweigen jeweils L-förmige Abzweigungen 8, 9 ab, die mit ihren längeren Schenkeln 10, 11 in Höhe einer Biegelinie 12 enden. Vom Steg 6 zweigen etwa auf der Höhe der Abzweigungen 8, 9 beidseitig L-förmige Abzweigungen 13, 14 in entgegengesetzte Richtungen ab. Die Abzweigungen 8, 9 sowie 13, 14 tragen an ihren Enden jeweils beidseitig angeformte Halterungen, die beim Zusammenbau der Schaltungsanordnung zur Halterung von Anschlüssen von Bauelementen dienen und zu diesem Zweck umgebogen werden. Die Bereiche 21, 22 sind bei dem in Fig. 1 dargestellten Blechformteil freigestanzt. Der Steg 6, der die Bereiche 21, 22 voneinander trennt, trägt an seinem Ende eine viereckige Arretierung 23, die beim Zusammenbau ebenfalls zur Befestigung von Bauteilanschlüssen dient.

Versetzt zu den Stegen 5, 7 und im Anschluß an die freigestanzten Bereiche 21, 22 verlaufen parallel zum Steg 6 Stege 24, 25, die an ihrem Ende abgewinkelt sind. An ihrem, zu den Anschlüssen 2 bis 4 zugewandten Enden tragen sie L-förmige, nach außen verlaufende Schenkel 26, 27 mit Halterungen 28, 29 an ihren Enden. Im Bereich dieser Halterungen 28, 29 verläuft parallel zur Biegelinie 12 eine weitere Biegelinie 30. Die Biegelinien 12 und 30 gliedern das Blechformteil 1 in die drei Bereiche I, II und III.

Beim Zusammenbau der Schaltungsanordnung werden der Bereich I von der Zeichenebene aus nach oben und der Bereich III nach hinten umgebogen, bis sie in einer senkrecht (Bereich I) bzw. parallel (Bereich III) zur Zeichenebene verlaufenden Ebene zu liegen kommen. Der Steg 6 trägt Öffnungen 32, in die Vorsprünge eines Trägerelements eingreifen. Das Trägerelement und das Blechformteil 1 können dann miteinander heißverstemmt werden, d.h. das Blechformteil wird auf das Trägerelement aufgesetzt, woraufhin die die Öffnungen 34 durchgreifenden Vorsprünge unter Hitzeeinwirkung zusammengepreßt werden. Dabei entsteht eine nietartige Verbindung.

In Fig. 2 ist die fertiggestellte Schaltungsanordnung dargestellt. Die durch eine Biegung veranderten Teile des Blechformteils 1 sind mit einem hochgestellten Strich gekennzeichnet.

Mit einem Trägerelement 31 ist das in Fig. 1 dargestellte Blechformteil 1′, das vor dem Zusammenbau entlang der Biegelinien 12, 30 gebogen wurde heißverstemmt. Die Anschlüsse 2′, 3′, 4′ sind mit drei Adern 36, 37, 38 eines Kabels 39 verbunden, das mit Hilfe einer Durchführung 40 arretiert ist. Zwischen dem Schenkel 10 des Steges 5 und dem Schenkel 26 des Steges 24 ist in Fig. 1 als elektrisches Bauelement ein Widerstand R₁ angeordnet. Er liegt dabei mit seinen Anschlüssen 41, 42 auf den Schenkeln 10, 26 auf und wird mit Hilfe der Halterungen 17′, 28′ fixiert. In den freigestanzten Bereichen 21, 22 sind ebenfalls Bauelemente, nämlich Kondensatoren C₂ und C₃, angeordnet. Das Bauelement C₂ liegt mit seinen Anschlüssen 43, 44 auf der Abzweigung 13 des Steges 6 und auf dem Schenkel 26 auf und wird durch die Halterungen 18′, 32′ festgehalten. Das Bauelement C₃ liegt mit seinen Anschlüssen 45, 46 auf der Abzweigung 14 und dem Schenkel 27 auf und wird über die Halterungen 19′, 33′ festgehalten. Anschlüsse 47, 48 eines weiteren Bauelements R₄ liegen in Fig. 2 auf den Schenkeln 11 des Steges 7 und dem Schenkel 27 des Steges 25 auf. Halterungen 20′, 29′ sorgen für die notwendige Fixierung.

Als weiteres Bauteil ist bei der Schaltungsanordnung von Fig. 2 ein Hall-Sensor 49 angeordnet, der über die Arretierung 23′ sowie in abgewinkelten Enden der Stege 24, 25 arretiert wird. Alle Anschlüsse der Bauteile der Schaltungsanordnung sind mit ihren jeweiligen Halterungen laserverschweißt.

## Patentansprüche

1. Elektrische Schaltungsanordnung mit einem aus einem temperaturbeständigem Kunststoff hergestellten Trägerelement (31), einer damit verbundenen Leiterbahnanordnung und elektrischen Bauelementen (R₁, C₂, C₃, R₄, 49), wobei die Leiterbahnanordnung als Blechformteil (1, 1′) ausgebildet ist und die Anschlüsse (41-48) der elektrischen Bauelemente (R₁, C₂, C₃, R₄, 49) mit dem Blechformteil (1, 1′) verschweißt sind.

2. Elektrische Schaltungsanordnung nach Anspruch 1, wobei das Blechformteil (1, 1′) als Blechstanz- und/oder Blechstanzbiegeteil ausgebildet ist.

3. Elektrische Schaltungsanordnung nach einem der Ansprüche 1 oder 2, wobei das Blechformteil (1, 1′) wenigstens teilweise flächig auf dem Trägerelement (31) aufliegt.

4. Elektrische Schaltungsanordnung nach einem der Ansprüche 1 bis 3, wobei das Trägerelement (31) Vorsprünge aufweist, die durch Öffnungen (34) im Blechformteil (1, 1′) greifen und mit dem Blechformteil (1, 1′) heißverstemmt sind.

5. Elektrische Schaltungsanordnung nach einem der Ansprüche 1 bis 4, dadurch gekennzeichnet, daß die Leiterbahnanordnung eingespritzt ist.

6. Elektrische Schaltungsanordnung nach einem der Ansprüche 1 bis 5, dadurch gekennzeichnet, daß die Anschlüsse (41-48) der elektrischen Bauelemente (R₁, C₂, C₃, R₄, 49) mit dem Blechformteil (1, 1′) Laserverschweißt sind.

7. Elektrische Schaltungsanordnung nach einem der Ansprüche 1 bis 6, dadurch gekennzeichnet, daß ein Bauelement als Sensor (49) ausgebildet ist.

8. Elektrische Schaltungsanordnung nach Anspruch 7, dadurch gekennzeichnet, daß der Sensor (49) als Bewegungssensor ausgebildet ist.

9. Elektrische Schaltungsanordnung nach Anspruch 7 oder 8, dadurch gekennzeichnet, daß mindestens eines der elektrischen Bauelemente als Hall-Sensor (49) ausgebildet ist.

10. Antriebsstrang eines Kraftfahrzeuges mit einem Sensor (49) der in einer Schaltungsanordnung nach einem der Ansprüche 1 bis 9 angeordnet ist und ein der Drehzahl eines Teils des Arbeitsstranges entsprechendes Signal erzeugt, wobei die Schaltungsanordnung in einem Bereich hoher Temperatur angeordnet ist.

11. Antriebsstrang nach Anspruch 10, wobei die Schaltungsanordnung in einem Motor angeordnet ist.

12. Antriebsstrang nach Anspruch 11, wobei der Motor ein Verbrennungsmotor ist.

13. Antriebsstrang nach Anspruch 10, wobei die Schaltungsanordnung in einem Getriebe angeordnet ist.

14. Antriebsstrang nach einem der Ansprüche 10 bis 13, wobei die Temperatur größer als 125 °C ist.

## Claims

1. An electrical circuit arrangement having a support element (31) manufactured from a temperature-resistant plastic, a strip conductor arrangement attached thereto and electrical components (R₁, C₂, C₃, R₄, 49), wherein the strip conductor arrangement is constructed as a sheet metal preform (1, 1′) and the connections (41-48) of the electrical components (R₁, C₂, C₃, R₄, 49) are welded to the sheet metal preform (1, 1′).

2. An electrical circuit arrangement according to claim 1, wherein the sheet metal preform (1, 1′) is constructed as a punched sheet metal part and/or a punched, bent sheet metal part.

3. An electrical circuit arrangement according to either one of claims 1 or 2, wherein the sheet metal preform (1, 1′) rests at least partially flat on the support element (31).

4. An electrical circuit arrangement according to any one of claims 1 to 3, wherein the support element (31) has projections which engage through openings (34) in the sheet metal preform (1, 1′) and which are hot-pressed to the sheet metal preform (1, 1′).

5. An electrical circuit arrangement according to any one of claims 1 to 4, characterised in that the strip conductor arrangement is injection-moulded in.

6. An electrical circuit arrangement according to any one of claims 1 to 5, characterised in that the connections (41-48) of the electrical components (R₁, C₂, C₃, R₄, 49) are laser-welded to the sheet metal preform (1, 1′).

7. An electrical circuit arrangement according to any one of claims 1 to 6, characterised in that one component is constructed as a sensor (49).

8. An electrical circuit arrangement according to claim 7, characterised in that the sensor (49) is constructed as a movement sensor.

9. An electrical circuit arrangement according to claim 7 or 8, characterised in that at least one of the electrical components is constructed as a Hall sensor (49).

10. A drive train of a motor vehicle having a sensor (49) which is disposed in a circuit arrangement according to any one of claims 1 to 9 and which generates a signal corresponding to the rotational speed of part of the drive train, wherein the circuit arrangement is disposed in a region of high temperature.

11. A drive train according to claim 10, wherein the circuit arrangement is disposed in an engine/motor.

12. A drive train according to claim 11, wherein the engine/motor is an internal combustion engine.

13. A drive train according to claim 10, wherein the circuit arrangement is disposed in a transmission.

14. A drive train according to any one of claims 10 to 13, wherein the temperature is higher than 125°C.

## Revendications

1. Circuit électrique comportant un élément de support (31) en une matière plastique thermorésistante, un ensemble de pistes conductrices qui y est relié et des composants électriques (R₁, C₂, C₃, R₄, 49), circuit dans lequel l'ensemble de pistes conductrices est constitué par une pièce métallique mince façonnée (1, 1′) et les bornes (41-48) des composants électriques (R₁, C₂, C₃, R₄, 49) sont soudées sur cette pièce façonnée (1, 1′).

2. Circuit électrique selon la revendication 1, dans lequel la pièce façonnée (1, 1′) est une pièce découpée et/ou découpée et pliée.

3. Circuit électrique selon l'une des revendications 1 ou 2, dans lequel la pièce façonnée (1, 1′) est appliquée, sur au moins une partie de sa surface, contre l'élément de support (31).

4. Circuit électrique selon l'une des revendications 1 à 3, dans lequel l'élément de support (31) présente des bossages qui passent dans des trous (34) de la pièce façonnée (1, 1′) et qui sont matés à chaud contre cette pièce métallique façonnée.

5. Circuit électrique selon l'une des revendications 1 à 3, caractérisé en ce que l'ensemble de pistes conductrices est enrobé par moulage par injection.

6. Circuit électrique selon l'une des revendications 1 à 5, caractérisé en ce que les bornes (41-48) des composants électriques (R₁, C₂, C₃, R₄, 49) sont soudées au laser à la pièce façonnée (1, 1′).

7. Circuit électrique selon l'une des revendications 1 à 6, caractérisé en ce que l'un des composants est un capteur (49).

8. Circuit électrique selon la revendication 7, caractérisé en ce que le capteur (49) est un capteur de mouvement.

9. Circuit électrique selon la revendication 7 ou 8, caractérisé en ce que l'un au moins des composants électriques est un capteur (49) à effet Hall.

10. Chaîne de traction d'automobile, comportant un capteur (49) qui est monté dans un circuit selon l'une des revendications 1 à 9 et qui émet un signal correspondant à la vitesse de rotation d'un élément de cette chaîne, dans laquelle ce circuit est disposé dans une zone à température élevée.

11. Chaîne de traction selon la revendication 10, dans laquelle le circuit est disposé dans le moteur.

12. Chaîne de traction selon la revendication 11, dans laquelle le moteur est un moteur à combustion interne.

13. Chaîne de traction selon la revendication 10, dans laquelle le circuit est disposé dans une boîte de vitesse.

14. Chaîne de traction selon l'une des revendications 10 à 13, dans laquelle la température est supérieure à 125 °C.
